# EUROPEAN PATENT APPLICATION

(11) **EP 4 764 024 A1**
(43) Date of publication of application: **24.06.2026**
(21) Application number: 25219032.7
(22) Date of filing: 27.11.2025
(51) Int. Cl.: C23C 14/06, C23C 14/16, C23C 14/32, C23C 14/34, C23C 14/58, C23C 16/02, C23C 16/26, B21B 27/02, C23C 28/00, B30B 3/00, H01M 4/04

(54) **ROLLER FOR ROLLING ELECTRODE SHEET COMPRISING HARD LAYER FORMED BY PHYSICAL VAPOR DEPOSITION AND MANUFACTURING METHOD OF THE SAME**

(30) Priority: 04.12.2024 KR 20240178325; 30.09.2025 KR 20250142125
(71) Applicant: J&L Tech Co., Ltd., Ansan-si, Gyeonggi-do 15618 (KR)
(72) Inventor: Jun, Joongil, 15454 Ansan-si, Gyeonggi-do (KR); Lee, Eunguk, 06270 Seoul (KR); Lee, Sounghun, 10492 Goyang-si, Gyeonggi-do (KR); Lim, Yongsoo, 15457 Ansan-si, Gyeonggi-do (KR)
(74) Representative: Gulde & Partner

(57) **Abstract**

A method for manufacturing a roller for rolling an electrode sheet, comprising a hard layer formed by physical vapor deposition (PVD) according to an embodiment of the present disclosure comprises: forming a hard layer by PVD on a roller core made of steel containing carbon; and polishing the hard layer so that a thickness of the hard layer at a center portion of the roller is different from a thickness of the hard layer at an end portion of the roller.

## Description

### CROSS-REFERENCE TO RELATED APPLICATION

This application claims the benefit of and priority to Korean Patent Application No. 10-2024-0178325 filed on December 4, 2024, and Korean Patent Application No. 10-2025-0142125 filed on September 30, 2025, the entire disclosures of which are incorporated herein by reference.

### TECHNICAL FIELD

The present disclosure relates to a roller (press roller) for rolling an electrode sheet comprising a hard layer formed by physical vapor deposition (PVD) and a manufacturing method of the same. Specifically, the present disclosure relates to a roller for rolling an electrode sheet comprising a hard layer formed by PVD method which is an environmentally friendly method that does not use materials that pollute the environment and are harmful to human body, and a manufacturing method of the roller.

### BACKGROUND

Generally, the electrode of a secondary battery is manufactured by coating an electrode material on a sheet, and a rolling process is performed on an electrode sheet coated with electrode material to increase the capacity density of the electrode, increase the adhesion between an electrode current collector and the electrode material, and form the electrode to a target thickness.

Meanwhile, the rollers used for rolling the electrode sheet are usually made of bearing steel, and in order to improve the wear resistance of the rollers and extend their lifespan, a Cr plating layer is sometimes formed using a wet plating method.

However, when forming a Cr plating layer using a wet plating method, Cr⁶⁺ is inevitably used. Meanwhile, Cr⁶⁺ is a highly toxic carcinogen and, with long-term exposure, can cause respiratory disease, dermatitis, kidney and liver damage in humans. Furthermore, Cr⁶⁺ not only has a negative impact on aquatic creatures, but also causes soil and water pollution.

Accordingly, the use of Cr⁶⁺ is expected to be banned in the future due to environmental regulations in each country around the world, and there is currently a problem that it is impossible to avoid an increase in unit price due to environmental burden when using Cr⁶⁺.

Accordingly, in manufacturing a roller for rolling electrode sheet, there is a growing need for a roller and a manufacturing method of the roller which are environmentally friendly while also improving wear resistance and extending lifespan.

### SUMMARY

The present disclosure is to solve the problems of the prior art described above, and an object of the present disclosure is to provide a roller for rolling an electrode sheet comprising a hard layer formed by physical vapor deposition (PVD) and a manufacturing method of the same.

However, the technical problems to be achieved by the embodiments of the present disclosure are not limited to the technical problems described above, and other technical problems may exist.

As a technical means for achieving the above technical problem, a method for manufacturing a roller for rolling an electrode sheet, comprising a hard layer formed by physical vapor deposition (PVD) according to an embodiment of the present disclosure comprises: forming a hard layer by PVD on a roller core made of steel containing carbon; and polishing the hard layer so that a thickness of the hard layer at a center portion of the roller is different from a thickness of the hard layer at an end portion of the roller.

Further, the forming of the hard layer may comprise: depositing a first hard layer made of a material selected from Cr, W and Ti; and depositing a second hard layer made of a material selected from CrₓN_{y} (x, y are numbers between 0 and 1), CrₓO_{y} (x, y are numbers between 0 and 1), CrC, WC, TiN and TiC.

Further, the forming of the hard layer may comprise: depositing a third hard layer on the second hard layer after depositing the first hard layer and depositing the second hard layer, and the third hard layer may be made of a material selected from Cr, W, Ti, CrₓN_{y}, CrₓO_{y}, CrC, WC, TiN and TiC.

Further, the forming of the hard layer may be performed by depositing Cr, W, Ti, CrₓN_{y} (x, y are numbers between 0 and 1), CrₓO_{y} (x, y are numbers between 0 and 1), CrC, WC, TiN or TiC on the roller core by a sputtering method or an arc deposition method as the PVD.

Further, the forming of the hard layer may comprise: performing primary polishing so that the thickness of the hard layer at the end portion of the roller becomes thinner than the thickness of the hard layer at the center portion of the roller; and performing mirror polishing so that a surface roughness of the hard layer becomes less than a predetermined value.

Further, the method may further comprise: after the polishing of the hard layer, forming a coating layer on the hard layer.

Further, the forming of the coating layer may comprise: forming at least one buffer layer by coating a metal material; and forming a diamond-like carbon (DLC) layer by ion beam deposition or chemical vapor deposition (CVD).

A roller for rolling an electrode sheet, comprising a hard layer formed by physical vapor deposition (PVD) according to an embodiment of the present disclosure comprises: a roller core made of steel containing carbon; and a hard layer formed on the roller core by PVD, wherein the hard layer is formed by polishing so that a thickness of the hard layer at a center portion of the roller is different from a thickness of the hard layer at an end portion of the roller.

Further, the hard layer may be formed so that the thickness of the hard layer at the end portion of the roller is thinner than the thickness of the hard layer at the center portion of the roller.

Further, the hard layer may comprise a first hard layer made of a material selected from Cr, W and Ti, and a second hard layer made of a material selected from CrₓN_{y} (x, y are numbers between 0 and 1), CrₓO_{y} (x, y are numbers between 0 and 1), CrC, WC, TiN and TiC.

The above-described means for solving the problem is only exemplary and should not be construed as limiting the present disclosure. In addition to the exemplary embodiments described above, additional embodiments may exist in the drawings and the following detailed description.

According to the problem-solving means of the present disclosure described above, it is possible to provide a roller for rolling an electrode sheet and a manufacturing method of the roller, that can solve environmental problems, prevent unit price increases due to environmental charges, and improve wear resistance and extend the life of the roller, by forming a hard layer in an eco-friendly manner.

Further, according to the means for solving the problems of the present disclosure, it is possible to provide a roller for rolling an electrode sheet and a manufacturing method of the roller, that can omit a dehydrogenation treatment to remove H (hydrogen) and metal oxide hydrogen (e.g., hydrogen chromate (H₂CrO₄ or H₂Cr₂O₇)) inevitably generated in the plating layer during wet plating, and can continuously perform the polishing operation of the hard layer, thereby improving productivity, and can also fundamentally prevent plating gassing defects that may occur after the dehydrogenation treatment.

However, the effects obtainable from the present disclosure are not limited to the effects described above, and other effects may exist.

### BRIEF DESCRIPTION OF THE DRAWINGS

FIG. 1 is a flowchart showing a manufacturing method of a roller for rolling an electrode sheet comprising a hard layer formed by physical vapor deposition (PVD) according to one embodiment of the present disclosure.
FIG. 2 is a flowchart specifically showing an embodiment of the step of forming the hard layer in the manufacturing method of the roller for rolling the electrode sheet comprising the hard layer formed by physical vapor deposition (PVD) according to one embodiment of the present disclosure.
FIG. 3 is a flowchart specifically showing an embodiment comprising a plurality of hard layers in the step of forming the hard layer in the manufacturing method of the roller for rolling the electrode sheet comprising the hard layer formed by physical vapor deposition (PVD) according to one embodiment of the present disclosure.
FIG. 4 is a flowchart specifically showing an embodiment of the step of polishing the hard layer in the manufacturing method of the roller for rolling the electrode sheet comprising the hard layer formed by physical vapor deposition (PVD) according to one embodiment of the present disclosure.
FIG. 5 is a flowchart showing a manufacturing method of a roller for rolling an electrode sheet comprising a hard layer formed by physical vapor deposition (PVD) according to another embodiment of the present disclosure.
FIG. 6 is a flowchart specifically showing an embodiment of the step of forming a coating layer in the manufacturing method of the roller for rolling the electrode sheet comprising the hard layer formed by physical vapor deposition (PVD) according to another embodiment of the present disclosure.
FIG. 7 is a side cross-sectional view of the roller for rolling the electrode sheet comprising the hard layer formed by physical vapor deposition (PVD) according to one embodiment of the present disclosure.
FIG. 8A is a cross-sectional view of a center portion of the roller for rolling the electrode sheet comprising a single hard layer formed by physical vapor deposition (PVD) according to one embodiment of the present disclosure, and FIG. 8B is a cross-sectional view of an end portion of the roller for rolling the electrode sheet comprising a single hard layer according to one embodiment of the present disclosure.
FIG. 9A is a cross-sectional view of a center portion of the roller for rolling the electrode sheet comprising a plurality of hard layers formed by physical vapor deposition (PVD) according to one embodiment of the present disclosure, and FIG. 9B is a cross-sectional view of an end portion of the roller for rolling the electrode sheet comprising a plurality of hard layers according to one embodiment of the present disclosure.
FIG. 10A is a cross-sectional view of a center portion of the roller for rolling the electrode sheet comprising a single hard layer formed by physical vapor deposition (PVD) and a coating layer according to another embodiment of the present disclosure, and FIG. 10B is a cross-sectional view of an end portion of the roller for rolling the electrode sheet comprising a single hard layer and a coating layer according to another embodiment of the present disclosure.

### DETAILED DESCRIPTION

Hereinafter, with reference to the accompanying drawings, embodiments of the present disclosure will be described in detail so that those skilled in the art can easily practice the embodiments. However, the present disclosure may be implemented in many different forms and is not limited to the embodiments described herein. In addition, in order to clearly describe the present disclosure in the drawings, parts irrelevant to the description are omitted, and similar reference numerals are attached to similar parts throughout the present disclosure.

Throughout the present disclosure, if a part is said to be "connected" to another part, it is not only "directly connected", but also "electrically connected" with another element in between, including cases where they are "indirectly connected".

Throughout the present disclosure, if one member is said to be located "on", "above", "under", or "below" the other member, this includes not only the case of being in contact with the other member, but also the case that another member is positioned between the two members.

Throughout the present disclosure, if a part "includes" a certain component, it does not mean excluding other components, and it does mean that it may further include other components, unless otherwise stated.

Various embodiments of the present disclosure generally relate to a rolling roller (press roller) comprising a hard layer formed by PVD (Physical Vapor Deposition) to prevent adverse effects on the environment and a manufacturing method of the roller.

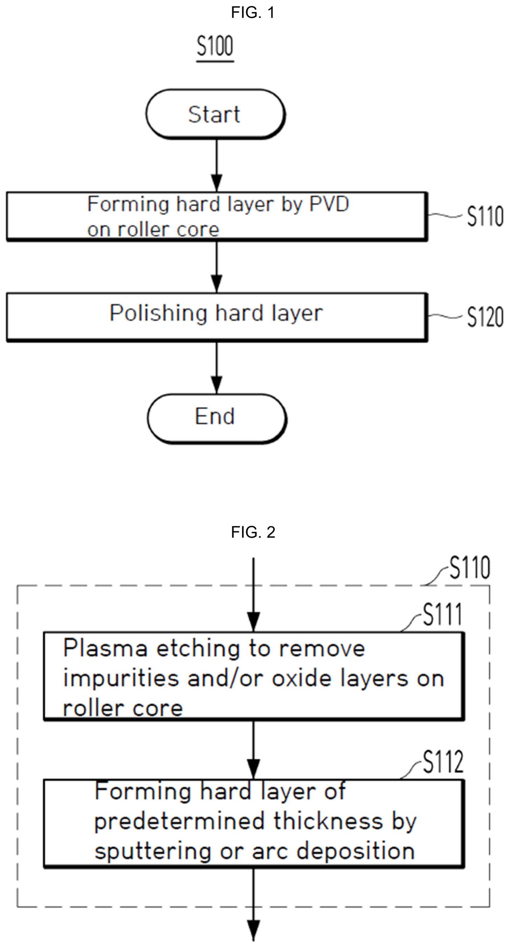

FIG. 1 is a flowchart showing a manufacturing method of a roller for rolling an electrode sheet comprising a hard layer formed by physical vapor deposition (PVD) according to one embodiment of the present disclosure.

Referring to FIG. 1, a manufacturing method of a roller for rolling an electrode sheet S100 according to one embodiment of the present disclosure may include a step of forming a hard layer S110 of forming a hard layer by PVD on a roller core made of a steel containing carbon.

The roller core may be made of a carbon-containing steel, for example, a bearing steel containing carbon and manganese. Additionally, the roller core may be formed in a cylindrical shape.

The PVD method is a dry deposition method, which means a method of performing deposition using only gas(es) without using liquid.

The hard layer formed by the PVD method may be made of a metal material, for example, chromium (Cr), tungsten (W), or titanium (Ti). Alternatively, the hard layer may be formed of a metal oxide such as chromium oxide (CrₓO_{y}), a metal nitride such as chromium nitride (CrₓN_{y}) or titanium nitride (TiN), or a metal carbide such as chromium carbide (CrC), tungsten carbide (WC) or titanium carbide (TiC), other than the metal material. Here, x and y may be any numbers between 0 and 1. Meanwhile, since the numbers expressed as x and y in the present disclosure are values for indicating the composition ratio between elements, x and y are expressed as numbers between 0 and 1. However, in the actual molecular formula, they may be numbers exceeding 1. In addition, in the present disclosure, chromium oxide is expressed as CrₓO_{y} and chromium nitride is expressed as CrₓN_{y}, but the x and y of chromium oxide may be different from x and y of chromium nitride, respectively.

However, the hard layer in the present disclosure is not limited to this, and may be formed by other materials if it is a material for improving the strength and wear resistance of the rolling roller (press roller).

Meanwhile, since the hard layer is intended to increase the strength and wear resistance of the roller core, it needs to be formed thicker than the coating layer (approximately 1 µm) that is generally formed on the roller. For example, the hard layer may be formed to a thickness of approximately 20 µm or more.

In addition, the hard layer may be formed to a thickness of 20 µm or more by continuously depositing a single layer (a layer comprising only one material), but may also be formed by discontinuously depositing the single layer (with a time interval) or by discontinuously depositing two or more layers (a plurality of layers).

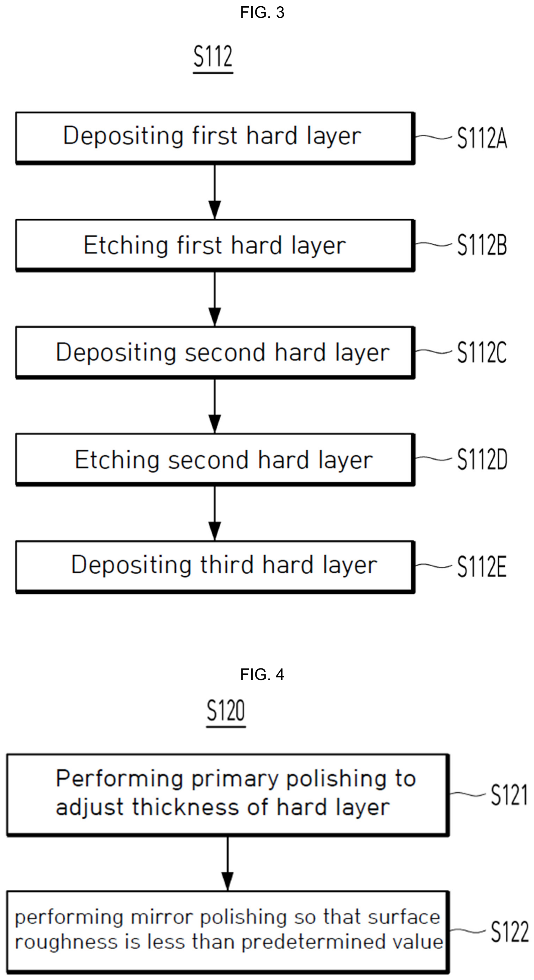

The embodiment of discontinuously depositing two or more layers will be explained in more detail in the description of FIG. 3.

Next, a step of polishing a hard layer S120 may be performed to polish the hard layer formed in the step of forming the hard layer so that the thicknesses of the hard layer at the center portion of the roller is different from the thickness of the hard layer at the end portion of the roller.

In the case of the rolling roller (press roller), if the thickness of the center portion of the roller and the thickness of the end portion are the same, the force (linear pressure) that the rolled electrode exerts to spread the roller becomes large, causing the roller to bend. Accordingly, when applying pressure to the electrode according to the rotation of the roller, the pressure is not applied uniformly, and the rolling of the electrode sheet may not be performed properly.

Therefore, in the step of polishing the hard layer S120, by making the thickness of the hard layer at the center portion different from the thickness of the hard layer at the end portion of the roller, bending of the rolling roller can be prevented, so that the pressure can be applied evenly when applying pressure to the electrode. More specifically, by making the thickness of the center portion of the roller thicker than the end (periphery) portion of the roller, the pressure can be applied evenly when rolling the electrode sheet.

Next, a step of forming a coating layer S130 of forming a coating layer on the hard layer on which polishing has been performed may be performed.

By forming the coating layer, the hardness and wear resistance of the roller surface can be improved, thereby preventing the occurrence of unevenness on the roller surface and improving the rolling quality of the electrode sheet.

According to the method for manufacturing the roller for rolling the electrode sheet according to one embodiment of the present disclosure, the strength and wear resistance of the roller can be improved, and at the same time, a remarkable effect can be exhibited in that the occurrence of environmental problems can be suppressed compared to the Cr plating forming method according to the existing wet deposition (wet plating) method.

In relation to this, in the past, Cr plating was performed by wet deposition to improve the wear resistance of the roller for rolling the electrode sheet, but according to the existing wet deposition method, environmental problems arise due to Cr⁶⁺.

In contrast, according to the embodiment of the present disclosure, by forming the hard layer on the roller core by dry deposition of a metal such as Cr or a metal nitride (or metal carbide) using the PVD method without using Cr⁶⁺, it is possible to prevent adverse effects on the environment.

FIG. 2 is a flowchart specifically showing an embodiment of the step of forming the hard layer in the manufacturing method of the roller for rolling the electrode sheet comprising the hard layer formed by physical vapor deposition (PVD) according to one embodiment of the present disclosure.

Referring to FIG. 2, the step of forming the hard layer according to one embodiment of the present disclosure may include a plasma etching step S111 of removing impurities and/or oxide layers on the roller core, and a hard layer forming step S112 of depositing a hard layer of a predetermined thickness by sputtering or arc deposition.

The plasma etching step S111 may be performed to remove impurities and/or oxide layers on the roller core, and may be performed at room temperature, for example, by ion beam etching or ion gun etching. By this plasma etching, the adhesion can be improved when depositing the hard layer on the roller core. When this ion beam or ion gun etching is performed, Ar gas may be used, and the plasma formation voltage may be 1 KV or higher, and the current may be 0.8 V or higher.

The hard layer forming step S112 of depositing the hard layer made of a material selected from Cr (chromium), W (tungsten), Ti (titanium), CrₓN_{y} (chromium nitride; x, y are numbers between 0 and 1), CrₓO_{y} (chromium oxide; x, y are numbers between 0 and 1), CrC (chromium carbide), WC (tungsten carbide), TiN (titanium nitride) and TiC (titanium carbide) on the roller core may be performed by sputtering or arc deposition of Cr, W, Ti, CrₓN_{y}, CrₓO_{y}, CrC, WC, TiN, or TiC. Further, HiPIMS may be used as a specific sputtering method.

HiPIMS (High Power Impulse Magnetron Sputtering) is a vacuum deposition technology that deposits thin films using high-power pulses. It may be a technology that can deposit high-quality films by significantly increasing the plasma density by applying short, high-power pulses.

In addition, the arc deposition method is a technology that uses an arc in a high vacuum environment to evaporate and deposit metal, and deposition may be performed by releasing materials through a small plasma jet that occurs on the target surface.

According to the HiPIMS or arc deposition method, the ionization rate of the material is high (over 50%), which may be advantageous in depositing a high-quality, high-density film. In addition, in order to increase the deposition speed of Cr, W, Ti, CrₓN_{y}, CrₓO_{y}, CrC, WC, TiN or TiC by the HiPIMS or arc deposition method, one or more targets of Cr, W, Ti, CrₓN_{y}, CrₓO_{y}, CrC, WC, TiN or TiC longer than the effective usable length of the roller may be used.

Deposition according to the sputtering or arc deposition method described above may be performed at a temperature above room temperature (15-25°C) and below 200°C. In order to improve the properties of the film (density, etc.) during deposition, it is necessary to perform deposition at a high temperature, but if the temperature is raised excessively, stress may increase. Therefore, by performing sputtering or arc deposition at a chamber temperature above room temperature and below 200°C, it is possible to form a hard layer that can minimize internal stress without causing layer peeling.

In addition, the gas used for sputtering may be Ar (argon) gas. For example, Ar gas may be flowed at 150 sccm or more, and the current required to maintain the plasma for sputtering may be 15 A or more.

Meanwhile, the plasma etching step S111 and the hard layer forming step S112 according to the sputtering or arc deposition method may be performed in the same chamber, and the hard layer formed by the sputtering or arc deposition method may be deposited until its thickness becomes approximately 20 µm or more.

In this regard, for the coatings formed by PVD method, films with a thickness of 5 µm or less are generally used for industrial applications, and it is difficult to use a film with a thickness of 20 µm or more due to a peeling phenomenon. Meanwhile, according to the sputtering or arc deposition process according to the embodiments of the present disclosure, a metal layer (hard layer) having a thickness of 20 µm or more, or even 150 µm or more, can be formed without a peeling phenomenon. In addition, when forming a plurality of hard layers, the hard layers can be formed so that the total thickness of the hard layers is 20 µm or more.

In addition, the formation of the hard layer by sputtering or arc deposition may be performed as a continuous process or in multiple stages. For example, if it is performed as a continuous process until the hard layer thickness of approximately 20 µm or more is formed, the time required to form the hard layer can be shortened, which may help improve productivity.

In addition, in the hard layer step S112 according to a sputtering or arc deposition method, the hard layer may be formed by performing a continuous process for one layer (single layer), or the single hard layer may be formed through a discontinuous process at intervals of time. If the single layer is formed through a discontinuous process, there is an advantage in that the size of the defect can be reduced.

Meanwhile, in the case of forming multiple (a plurality of) hard layers (two or more layers), deposition may be performed through a discontinuous process, and in this case, a metal (chromium, tungsten, or titanium) layer and an oxide film (or nitride/carbide film) layer may be formed alternately. Hereinafter, an embodiment of forming multiple hard layers will be described with reference to FIG. 3.

FIG. 3 is a flowchart specifically showing an embodiment comprising a plurality of hard layers in the step of forming the hard layer in the manufacturing method of the roller for rolling the electrode sheet comprising the hard layer formed by physical vapor deposition (PVD) according to one embodiment of the present disclosure.

Referring to FIG. 3, the hard layer forming step S112 according to the sputtering or arc deposition method may include a first hard layer deposition step S112A of depositing a first hard layer made of a material selected from Cr (chromium), W (tungsten) and Ti (titanium), and a second hard layer deposition step S112C of depositing a second hard layer made of a material selected from CrₓN_{y} (chromium nitride), CrₓO_{y} (chromium oxide), CrC (chromium carbide), WC (tungsten carbide), TiN (titanium nitride) and TiC (titanium carbide).

In addition, a first hard layer etching step S112B of etching the first hard layer may be additionally performed between the first hard layer deposition step S112A and the second hard layer deposition step S112C. The first hard layer etching step S112B may be performed by plasma etching.

By discontinuously depositing multiple layers in this way, a metal (e.g., chromium, tungsten, or titanium) layer and an oxide film (or nitride/carbide film) layer are alternately formed, thereby ensuring surface roughness and also achieving stress relief.

Meanwhile, it may be more advantageous for the first hard layer and the second hard layer to be of the same metal series to achieve stress relief. For example, if the first hard layer is a Cr (chromium) layer, it may be advantageous for the second hard layer to be a CrₓO_{y} (chromium oxide), CrₓN_{y} (chromium nitride) or CrC (chromium carbide) layer to achieve the stress relief.

Meanwhile, as shown in FIG. 3, in addition to the discontinuous deposition of the first hard layer and the second hard layer, a third hard layer deposition step S112E of additionally depositing a third hard layer on the second hard layer may be performed. The third hard layer may be made of a material selected from, for example, Cr (chromium), W (tungsten), Ti (titanium), CrₓN_{y} (chromium nitride), CrₓO_{y} (chromium oxide), CrC (chromium carbide), WC (tungsten carbide), TiN (titanium nitride) and TiC (titanium carbide).

In addition, a second hard layer etching step S112D of etching the second hard layer may be additionally performed between the second hard layer deposition step S112C and the third hard layer deposition step S112E. The second hard layer etching step S112D may be performed by plasma etching.

Meanwhile, it may be more advantageous for the first hard layer, the second hard layer, and the third hard layer to be of the same metal series to achieve stress relief. For example, if the first hard layer is a Cr (chromium) layer, the second hard layer may be a CrₓO_{y} (chromium oxide), CrₓN_{y} (chromium nitride) or CrC (chromium carbide) layer, and the third hard layer may be a Cr (chromium) layer to achieve the stress relief.

In the embodiment of FIG. 3, three layers are deposited discontinuously, but the present disclosure is not limited thereto, and two or more layers may be included in the scope of the present disclosure. That is, the hard layer of the present disclosure may be formed by depositing only two layers, or may be formed by depositing four or more layers. For example, the hard layer may include five layers in which a Cr layer, a CrₓO_{y} layer, a Cr layer, a CrₓO_{y} layer and a Cr layer are sequentially deposited, so that the Cr layer and the CrₓO_{y} layer are repeatedly formed. In addition, the thickness of each hard layer may be the same, but the present disclosure is not limited thereto, and the thickness of each hard layer may be different as needed.

Meanwhile, when forming multiple hard layers, the outermost (uppermost) hard layer may be made of a material having a higher hardness than the hard layer formed immediately before the outermost hard layer (the hard layer immediately below the uppermost hard layer). By forming the hard layer it in this manner, it is possible to improve the lifespan of the roller.

For example, in a case where the hard layer is composed of only the first hard layer and the second hard layer, if the first hard layer is a Cr (chromium) layer, the second hard layer may be a CrₓO_{y} (chromium oxide) layer having a higher hardness than Cr.

However, in situations where the deposition speed (deposition rate) of the hard layer is more important, the outermost hard layer may be formed of a material having a lower hardness than the hard layer formed immediately before the outermost hard layer. For example, if the first hard layer is a Cr layer and the second hard layer is a CrₓO_{y} layer, the third hard layer may be a Cr layer.

Specifically, since the deposition rate of the metal layer is higher than that of the metal oxide (or nitride/carbide) layer, in cases where yield improvement is important, the effect of increasing the deposition rate of the entire hard layer can be achieved by forming the first hard layer and the third hard layer, which are metal layers, thicker than the second hard layer.

As described above, in the case of discontinuous deposition to form multiple (two or more) hard layers in the hard layer forming step, deposition may be performed in multiple steps at a predetermined thickness, and in this case, the thickness of the entire hard layer may be approximately 20 µm or more.

FIG. 4 is a flowchart specifically showing an embodiment of the step of polishing the hard layer in the manufacturing method of the roller for rolling the electrode sheet comprising the hard layer formed by physical vapor deposition (PVD) according to one embodiment of the present disclosure.

Referring to FIG. 4, the step of polishing the hard layer S120 according to one embodiment of the present disclosure may include a primary polishing step S121 of adjusting the thickness of the hard layer and a mirror polishing step S122 of performing mirror polishing so that the surface roughness becomes less than a predetermined value.

In the primary polishing step S121, a thickness adjustment operation that makes the thickness of the hard layer different at the center portion and the end portion of the roller may be performed by a polishing machine. More specifically, polishing may be performed so that the thickness of the hard layer at the center portion of the roller becomes thicker than the thickness of the hard layer at the end portion (periphery portion) of the roller.

For example, if the thickness of the hard layer at the center portion of the roller is 20 µm, polishing may be performed so that the thickness of the hard layer at the end portion becomes 10 µm.

Meanwhile, in order to ensure that pressure is applied evenly to the electrode sheet, it is preferable that the thickness difference between the center and the end of the roller be 10 to 15 µm.

The reason for forming a hard layer on the roller core is to increase the strength of the roller core, so the minimum thickness of the hard layer needs to be 10 µm or more.

Accordingly, the thickness of the hard layer at the end portion of the roller after polishing may be 10 µm or more, and the deposition thickness of the hard layer formed on the roller core (deposition thickness deposited by PVD method) needs to be 20 µm or more so that the thickness difference between the center portion and the end portion can be approximately 10 to 15 µm.

In addition, after performing primary polishing to adjust the thickness of the hard layer, surface polishing (mirror polishing) may be performed to smooth the surface of the hard layer (S122).

In the mirror polishing step S122, polishing may be performed to smooth the surface until the surface roughness of the hard layer becomes less than a predetermined value. For example, the mirror polishing may be performed until the surface roughness Ra of the hard layer becomes less than 0.02.

Meanwhile, according to the existing wet plating method, H is inevitably included within the plating layer due to wet plating. Therefore, after the primary polishing, it is necessary to perform heat treatment (dehydrogenation treatment) to remove H (hydrogen) and metal oxide hydrogen (e.g., hydrogen chromate (H₂CrO₄ or H₂Cr₂O₇, etc.).

However, according to the present disclosure using PVD, the dehydrogenation heat treatment for removing H (hydrogen) and the like within the hard layer can be omitted, and the primary polishing and mirror polishing (secondary polishing) can be performed continuously. Accordingly, the effects of improving work efficiency and shortening work time can be achieved.

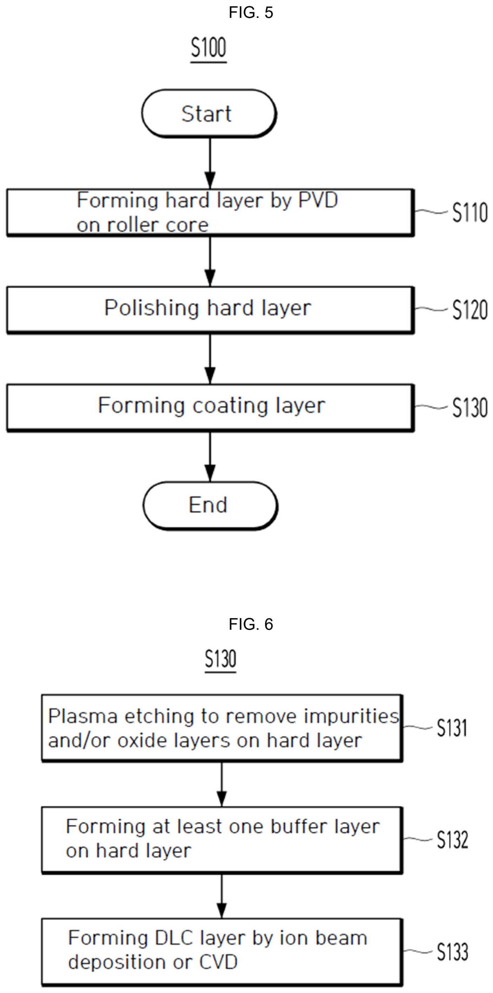

FIG. 5 is a flowchart showing a manufacturing method of a roller for rolling an electrode sheet comprising a hard layer formed by physical vapor deposition (PVD) according to another embodiment of the present disclosure.

Referring to FIG. 5, the manufacturing method of the roller for rolling the electrode sheet comprising the hard layer formed by physical vapor deposition (PVD) according to another embodiment of the present disclosure may further include a step of forming a coating layer S130 of forming a coating layer on the hard layer after the hard layer polishing step S120 in FIG. 1.

FIG. 6 is a flowchart specifically showing an embodiment of the step of forming a coating layer in the manufacturing method of the roller for rolling the electrode sheet comprising the hard layer formed by physical vapor deposition (PVD) according to another embodiment of the present disclosure.

The step of forming the coating layer S130 may include a plasma etching step S131 of removing impurities and/or oxide layers on the hard layer. By the plasma etching step, in forming the coating layer on the hard layer that has been mirror-polished, adhesion can be improved. The plasma etching may be performed, for example, by ion beam etching.

After the plasma etching step S131, a buffer layer forming step S132 of forming at least one buffer layer on the hard layer may be performed, and then a DLC layer forming step S133 of forming a diamond-like carbon (DLC) layer on the buffer layer by ion beam deposition or CVD (Chemical Vapor Deposition) may be performed.

The DLC layer may be a coating layer formed to provide high surface hardness, wear resistance, and lubrication to the surface of the roller, and DLC (diamond-like carbon) has a structure that is an intermediate structure of diamond and graphite mixed together, and has high hardness similar to diamond and excellent wear resistance, solid lubrication, thermal conductivity, chemical stability, and corrosion resistance.

Meanwhile, before forming the DLC layer, the adhesion of the DLC layer can be improved and the DLC layer can be prevented from being peeled off from the hard layer by forming at least one buffer layer (e.g., two buffer layers).

At least one buffer layer may include, for example, a first buffer layer and a second buffer layer. The first buffer layer may prevent oxidation of the surface of the roller and secures primary surface strength to respond to the rolling load transmitted through the outer DLC layer, and the second buffer layer may be formed for smooth attachment (for securing adhesion of the coating film) when forming the DLC layer.

The first buffer layer and the second buffer layer may be formed by various thin film forming methods such as sputtering, vacuum deposition, ion plating, molecular beam epitaxy, laser ablation, and ion assisted methods.

For example, the first buffer layer may be formed as a coating layer of any one of Cr (chromium), W (tungsten), Ti (titanium) and Zr (zirconium) by sputtering the metal, and may be formed to a thickness in the range of 0.1 µm to 2 µm.

In addition, the second buffer layer may be coated with a nitride or carbide of the same metal as the first buffer layer (for example, CrₓN_{y}, CrₓC_{y}, CrₓC_{y}N_{z}, etc. if the first buffer layer is Cr; x, y, z are numbers between 0 and 1), and has a lattice constant and a thermal expansion coefficient corresponding to those of the first buffer layer and the DLC layer, so that when coated, particle attachment is ensured, and adhesion between the coating layers is excellent, and also, internal stress change according to temperature is reduced, which can help prevent delamination between layers. The second buffer layer may be formed with a thickness in the range of 0.1 µm to 1 µm.

The DLC layer may be formed on the buffer layer by ion beam deposition or CVD (Chemical Vapor Deposition) method. For example, the DLC layer may be coated using an ion beam (ion gun) source. During coating, the voltage may be 500 to 3000 V and the current may be 0.2 to 3 A, and the gas used as the deposition source may be a hydrocarbon (CₓH_{y}) series gas such as CH₄, C₂H₂, C₆H₆, C₄H₁₀, etc. When forming the DLC layer, the DLC layer may be formed by adding F to control the contact angle or adding Si to control the friction coefficient.

For example, the DLC layer may be formed with a thickness of 0.1 µm to 3 µm. If the thickness of the DLC layer is less than 0.1 µm, the wear resistance and durability of the roller are significantly reduced, and if it exceeds 3 µm, the internal stress of the coating film itself is formed to be excessively high, making it easy to peel off.

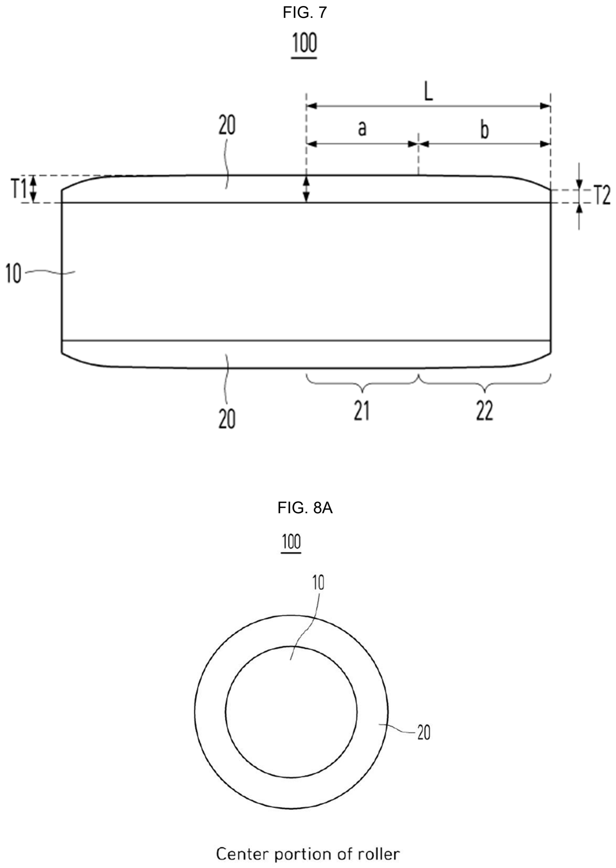

FIG. 7 is a side cross-sectional view of the roller for rolling the electrode sheet comprising the hard layer formed by physical vapor deposition (PVD) according to one embodiment of the present disclosure.

Referring to FIG. 7, a hard layer 20 may be formed on a cylindrical roller core 10, and the hard layer 20 may be formed with a different thickness at the center of the roller and an end of the roller.

For example, as shown in FIG. 7, the hard layer 20 according to one embodiment of the present disclosure may include a first region 21 having a constant thickness and a length a toward the center, and a second region 22 having a length b and a thickness that becomes thinner toward the end, and the thickness T1 at the center of the roller may be *20* µm or more, and the thickness T2 at the end of the roller may be 10 µm or more.

In the embodiment of FIG. 7, an embodiment is illustrated that includes a first region 21 having the same thickness as the center and a second region 22 having a thickness that becomes thinner as it goes toward the end, but it is not limited thereto, and for example, it may be formed so that the thickness continuously becomes thinner from the center to the end.

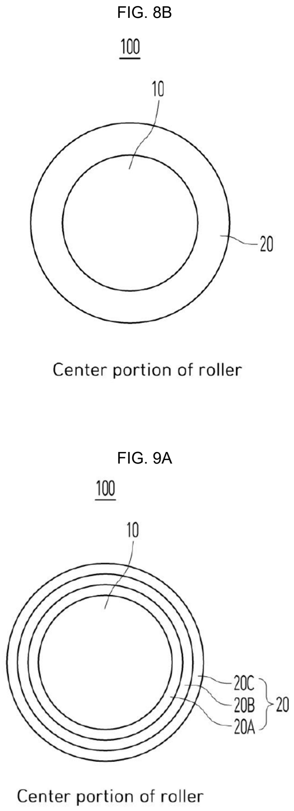

FIG. 8A is a cross-sectional view of a center portion of the roller for rolling the electrode sheet comprising a single hard layer formed by physical vapor deposition (PVD) according to one embodiment of the present disclosure, and FIG. 8B is a cross-sectional view of an end portion of the roller for rolling the electrode sheet comprising a single hard layer according to one embodiment of the present disclosure.

As shown in FIGS. 8A and 8B, the roller 100 according to the embodiment of the present disclosure may include a roller core 10 made of a steel containing carbon, and a hard layer 20 formed on the roller core 10 by a PVD method, specifically, a sputtering or arc deposition method.

The method of forming a hard layer 20 on the roller core 10 has been described in detail above, so a detailed description will be omitted here.

As can be seen in FIGS. 8A and 8B, the hard layer 20 may be formed with different thicknesses at the center portion and the end portion of the roller through a polishing process after deposition by PVD. Specifically, the hard layer 20 according to the embodiment of the present disclosure may be formed so that the thickness of the hard layer at the end portion of the roller is thinner than the thickness of the hard layer at the center portion of the roller.

Specifically, in FIG. 8A, the thickness of the hard layer 20 at the center portion of the roller may be 20 µm or more, and in FIG. 8B, the thickness of the hard layer 20 at the end portion of the roller may be 10 µm or more. Meanwhile, in order to improve rolling performance, it is preferable that the difference between the thickness of the hard layer 20 at the center portion of the roller and the thickness of the hard layer 20 at the end portion of the roller be approximately 10 to 15 µm.

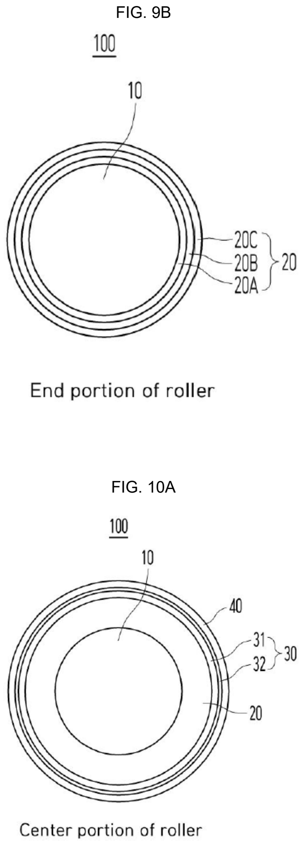

FIG. 9A is a cross-sectional view of a center portion of the roller for rolling the electrode sheet comprising a plurality of hard layers formed by physical vapor deposition (PVD) according to one embodiment of the present disclosure, and FIG. 9B is a cross-sectional view of an end portion of the roller for rolling the electrode sheet comprising a plurality of hard layers according to one embodiment of the present disclosure.

As shown in FIGS. 9A and 9B, in an embodiment including a plurality of hard layers, the hard layer 20 may include a first hard layer 20A, a second hard layer 20B and a third hard layer 20C. Each hard layer may be formed by a PVD method, specifically, sputtering or arc deposition.

In FIG. 9A, the thickness of the hard layer 20 at the center portion of the roller (the sum of the thicknesses of the first to third hard layers) may be 20 µm or more, and in FIG. 9B, the thickness of the hard layer 20 at the end portion of the roller (the sum of the thicknesses of the first to third hard layers) may be 10 µm or more. Meanwhile, the thicknesses of the first hard layer 20A, the second hard layer 20B and the third hard layer 20C may be the same, but the present disclosure is not limited thereto, and the thicknesses of each hard layer may be different as needed.

In addition, in order to improve rolling performance, it is preferable that the difference in thickness between the hard layer 20 at the center portion of the roller and the hard layer 20 at the end portion of the roller be approximately 10 to 15 µm.

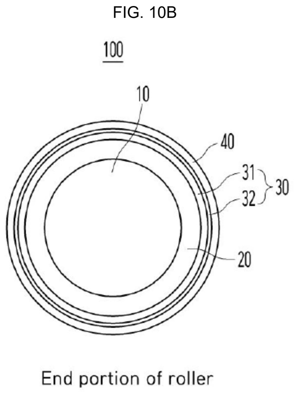

FIG. 10A is a cross-sectional view of a center portion of the roller for rolling the electrode sheet comprising a single hard layer formed by physical vapor deposition (PVD) and a coating layer according to another embodiment of the present disclosure, and FIG. 10B is a cross-sectional view of an end portion of the roller for rolling the electrode sheet comprising a single hard layer and a coating layer according to another embodiment of the present disclosure.

As shown in FIGS. 10A and 10B, a roller 100 according to another embodiment of the present disclosure may include a roller core 10 made of steel containing carbon, a hard layer 20 formed by a PVD method on the roller core 10, and at least one coating layer 30, 40 formed on the hard layer 20.

The coating layer may include, for example, a first buffer layer 31, a second buffer layer 32 and a DLC layer 40. The method of forming the hard layer 20 on the roller core 10 and the method of forming the first buffer layer 31, the second buffer layer 32 and the DLC layer 40 on the hard layer 20 have been described in detail above, so a detailed description thereof will be omitted here.

As can be seen in FIGS. 10A and 10B, the hard layer 20 may be formed with different thicknesses at the center portion and the end portion of the roller through a polishing process after deposition by PVD. Specifically, the hard layer 20 according to the embodiment of the present disclosure may be formed so that the thickness of the hard layer at the end portion of the roller is thinner than the thickness of the hard layer at the center portion of the roller.

Specifically, the thickness of the hard layer 20 at the center portion of the roller in FIG. 10A may be 20 µm or more, and the thickness of the hard layer 20 at the end of the roller in FIG. 10B may be 10 µm or more. Meanwhile, in order to improve rolling performance, it is preferable that the difference between the thickness of the hard layer 20 at the center portion of the roller and the thickness of the hard layer 20 at the end portion of the roller be approximately 10 to 15 µm.

In addition, the thickness of the first buffer layer 31 may be approximately 0.1 µm to 2 µm, the thickness of the second buffer layer 32 may be approximately 0.1 µm to 1 µm, and the thickness of the DLC layer 40 may be approximately 0.1 µm to 3 µm. As can be seen in FIGS. 10A and 10B, the first buffer layer 31, the second buffer layer 32 and the DLC layer 40 may all be formed to have the same thickness at the center portion and end portion of the roller.

Meanwhile, although the above embodiment exemplifies the formation of a first buffer layer 31 and a second buffer layer 32, it is also possible to form only one buffer layer and form a DLC layer 40 on the buffer layer. In addition, the present disclosure is not limited thereto, and the formation of the coating layer in the present disclosure may be possible in various embodiments.

According to the above-described embodiments of the present disclosure, it is possible to provide a roller for rolling an electrode sheet and a manufacturing method of the roller that can solve an environmental problem by forming a hard layer by PVD, which is an environmentally friendly method, can promote wear resistance and an extension of the lifespan of the roller, which cannot be predicted from the prior art.

In addition, according to the roller for rolling the electrode sheet including a hard layer formed by physical vapor deposition (PVD) and the manufacturing method of the same according to the embodiments of the present disclosure, the dehydrogenation treatment inevitably required during wet plating can be omitted, and the polishing operation of the hard layer can be performed continuously, thereby improving productivity and fundamentally preventing the occurrence of defects that may occur after the dehydrogenation treatment.

The above description of the present disclosure is for illustrative purposes, and those skilled in the art may understand that it can be easily modified into other specific forms without changing the technical spirit or essential features of the present disclosure. Therefore, the embodiments described above should be understood as illustrative in all respects and not limiting. For example, each component described as a single type may be implemented in a distributed manner, and similarly, components described as distributed may be implemented in a combined form.

The scope of the present disclosure is indicated by the following claims rather than the above detailed description, and all changes or modifications derived from the meaning and scope of the claims and equivalent concepts should be interpreted to be included in the scope of the present disclosure.

### EXPLANATION OF REFERENCE

100: Roller for rolling electrode sheet comprising hard layer formed by PVD
10: Roller core
20: Hard layer
20A: First hard layer
20B: Second hard layer
20C: Third hard layer
21: First region
22: Second region
30: Buffer layer
31: First buffer layer
32: Second buffer layer
40: DLC layer

## Claims

1. A method for manufacturing a roller for rolling an electrode sheet, comprising a hard layer formed by physical vapor deposition (PVD), the method comprising:
forming a hard layer by PVD on a roller core made of steel containing carbon; and
polishing the hard layer so that a thickness of the hard layer at a center portion of the roller is different from a thickness of the hard layer at an end portion of the roller.

2. The method of claim 1, wherein the forming of the hard layer comprises:
depositing a first hard layer made of a material selected from Cr, W and Ti; and depositing a second hard layer made of a material selected from CrₓN_{y} (x, y are numbers between 0 and 1), CrₓO_{y} (x, y are numbers between 0 and 1), CrC, WC, TiN and TiC.

3. The method of claim 2, wherein the forming of the hard layer comprises:
depositing a third hard layer on the second hard layer after depositing the first hard layer and depositing the second hard layer, and
wherein the third hard layer is made of a material selected from Cr, W, Ti, CrₓN_{y} (x, y are numbers between 0 and 1), CrₓO_{y} (x, y are numbers between 0 and 1), CrC, WC, TiN and TiC.

4. The method of any one of claims 1 to 3, wherein the forming of the hard layer is performed by depositing Cr, W, Ti, CrₓN_{y} (x, y are numbers between 0 and 1), CrₓO_{y} (x, y are numbers between 0 and 1), CrC, WC, TiN or TiC on the roller core by a sputtering method or an arc deposition method as the PVD.

5. The method of any one of claims 1 to 3, wherein the forming of the hard layer comprises: performing primary polishing so that the thickness of the hard layer at the end portion of the roller becomes thinner than the thickness of the hard layer at the center portion of the roller; and performing mirror polishing so that a surface roughness of the hard layer becomes less than a predetermined value.

6. The method of any one of claims 1 to 3, further comprising:
after the polishing of the hard layer, forming a coating layer on the hard layer.

7. The method of claim 6, wherein the forming of the coating layer comprises:
forming at least one buffer layer by coating a metal material; and forming a diamond-like carbon (DLC) layer by ion beam deposition or chemical vapor deposition (CVD).

8. A roller for rolling an electrode sheet, comprising a hard layer formed by physical vapor deposition (PVD), comprising:
a roller core made of steel containing carbon; and
a hard layer formed on the roller core by PVD,
wherein the hard layer is formed by polishing so that a thickness of the hard layer at a center portion of the roller is different from a thickness of the hard layer at an end portion of the roller.

9. The roller of claim 8, wherein the hard layer is formed so that the thickness of the hard layer at the end portion of the roller is thinner than the thickness of the hard layer at the center portion of the roller.

10. The roller of claim 8, wherein the hard layer comprises a first hard layer made of a material selected from Cr, W and Ti, and a second hard layer made of a material selected from CrₓN_{y} (x, y are numbers between 0 and 1), CrₓO_{y} (x, y are numbers between 0 and 1), CrC, WC, TiN and TiC.
